# EUROPÄISCHE PATENTSCHRIFT

(11) **EP 1 358 502 B1**
(45) Veröffentlichungstag und Bekanntmachung des Hinweises auf die Patenterteilung: **26.10.2005**
(21) Anmeldenummer: 02701230.1
(22) Anmeldetag: 25.01.2002
(51) Int. Cl.: G01R 33/09

(54) **GMR-STRUKTUR UND VERFAHREN ZU DEREN HERSTELLUNG**
GMR STRUCTURE AND METHOD FOR THE PRODUCTION THEREOF
STRUCTURE GMR ET SON PROCEDE DE FABRICATION

(30) Priorität: 30.01.2001 DE 10103868
(43) Veröffentlichungstag der Anmeldung: 05.11.2003
(73) Patentinhaber: ROBERT BOSCH GMBH, 70442 Stuttgart (DE)
(72) Erfinder: GRUEN, Detlef, 72760 Reutlingen (DE); FISCHER, Frank, 72810 Gomaringen (DE); SIEGLE, Henrik, 71229 Leonberg (DE); HEIN, Peter, 72770 Reutlingen (DE)
(86) Internationale Anmeldenummer: PCT/DE2002/000243
(87) Internationale Veröffentlichungsnummer: WO 2002/061446

(56) Entgegenhaltungen:
- EP-A- 0 727 773
- US-A- 5 650 958
- ROSS M: "GMR: AN ATTRACTIVE RESISTANCE" EUROPHYSICS NEWS, BERLIN, DE, Juli 1997 (1997-07), Seiten 114-118, XP000904550 ISSN: 0531-7479

## Beschreibung

Die Erfindung betrifft ein Verfahren zum Herstellen einer GMR-Struktur ("Giant-Magneto-Resistance-Struktur"), bei dem auf einen Träger eine metallische Vielfachschicht aufgebracht wird und bei dem die metallische Vielfachschicht zum Erzeugen der GMR-Struktur strukturiert wird. Die Erfindung betrifft ferner eine GMR-Struktur mit einem Träger und einer auf dem Träger angeordneten strukturierten metallischen Vielfachschicht.

### Stand der Technik

Weg- und Winkelsensoren, die auf magnetischer Basis, arbeiten, finden beispielsweise in der Kraftfahrzeugtechnologie zahlreiche Anwendungen. Besondere Vorzüge liegen darin, dass die Sensoren berührungslos und daher ohne mechanischen Verschleiß arbeiten. Sie sind robust gegenüber Verschmutzungen, und sie widerstehen hohen Temperaturen. Herkömmliche Magnetsensoren beruhen beispielsweise auf dem Hall-Effekt oder auf einem AMR-Effekt ("Anisotropic-Magneto-Resistance-Effekt").

Dokumente EP 0 953 849, US 56 50 958 und EP 07 27 773 beschreiben ebenfalls Verschiedene GMR-Strukturen.

Neuerdings werden für die genannte "Positionssensorik" neue Sensorkonzepte verwendet, welche den Riesenmaqneto-widerstandseffekt oder GMR-Effekt nutzen. Dieser Effekt beruht darauf, dass Elektronen aufgrund ihrer quantisierten Spinzustände beim Durchgang durch magnetische Schichten je nach Ausrichtung der Magnetisierung dieser Schichten unterschiedlich stark gestreut werden. Bei paralleler Magnetisierung ist die Streuung geringer als bei antiparallel angeordneter Magnetisierung. Dies führt zu einer Änderung des elektrischen Widerstandes in Abhängigkeit des äußeren Magnetfeldes, in welchem sich eine GMR-Struktur befindet. Die Bedeutung für die Positionssensorik ergibt sich nun daraus, dass ein äußeres Magnetfeld von einem magnetischen Element, etwa einem Rotor oder auch einem sich geradlinig bewegenden Element, beeinflusst wird, wobei sich diese Beeinflussung im elektrischen Widerstand der GMR-Struktur zeigt.

Es sind hohe Anforderungen an die Messung der Widerstände der Schichtanordnungen zu stellen, da der Widerstand die entscheidende Größe für den Rückschluss auf das zu vermessende Magnetfeld ist. Besonders genaue Messverfahren beruhen auf der bekannten Wheatstone-Brückenschaltung. Eine solche Wheatstone-Brückenschaltung kann beispielsweise vier GMR-Elemente enthalten.

Verfahren des Standes der Technik zum Herstellen von GMR-Elementen beruhen auf der Abscheidung von magnetischen und unmagnetischen Vielfachschichten auf einem isolierenden Untergrund. Nach der Metallabscheidung erfolgt die Strukturierung der Metallebene typischerweise mittels Trockenätzverfahren. Als ein solches Trockenätzverfahren bietet sich beispielsweise das Ionenstrahlätzen IBE ("Ion beam etching"), ein RF-Sputterverfahren oder die lift-off-Technik an. Nachfolgend werden die elektrischen Kontakte auf dem GMR-Element angebracht. Daraufhin werden Passivierungsschichten abgeschieden.

Die vorliegende Erfindung betrifft ein Verfahren zum Herstellen einer GMR-Struktur nach Anspruch 1, eine GMR-Struktur nach Anspruch 10 und die Verwendung einer GMR-Struktur nach Anspruch 13.

Die Figuren 1 bis 7 veranschaulichen ein Verfahren des Standes der Technik zum Herstellen einer GMR-Struktur. Es sind jeweils Zwischenzustände während des Verfahrensablaufs in Schnittdarstellung durch eine Schichtanordnung dargestellt.

Figur 1 zeigt ein Halbleitersubstrat 110, beispielsweise Silizium, mit einer darüberliegenden Isolationsschicht 112.

Figur 2 zeigt die Anordnung gemäß Figur 1 mit einer zusätzlich auf die Isolationsschicht 112 aufgebrachte metallische Vielfachschicht 114. Diese metallische Vielfachschicht 114, welche man gemäß ihrer späteren Funktion auch als GMR-Schicht bezeichnen kann, wird beispielsweise durch einen Abscheidungsprozess aufgebracht. Hierzu kann zum Beispiel ein DC-Magnetron-Sputter-Prozess verwendet werden. Die GMR-Schicht besteht beispielsweise aus Co/Cubeziehungsweise FeCr/Cu-Schichten. Sie hat typischerweise insgesamt eine Dicke von ca. 100 nm.

In Figur 3 ist die Schichtanordnung gemäß Figur 2 mit einer zusätzlich auf der metallischen Vielfachschicht 114 durch Photolithographie angeordneten Lackmaske 160 dargestellt. Diese Lackmaske 160 dient der Strukturierung der GMR-Schicht.

In Figur 4 ist ein Zustand dargestellt, welcher auf dem Zustand gemäß Figur 3 aufbaut, und in dem die GMR-Schicht 114 bereits strukturiert ist. Dies kann beispielsweise durch Trockenätzen, etwa mit IBE, erfolgt sein. Ferner wurde die Lackmaske 160 gemäß Figur 3 entfernt.

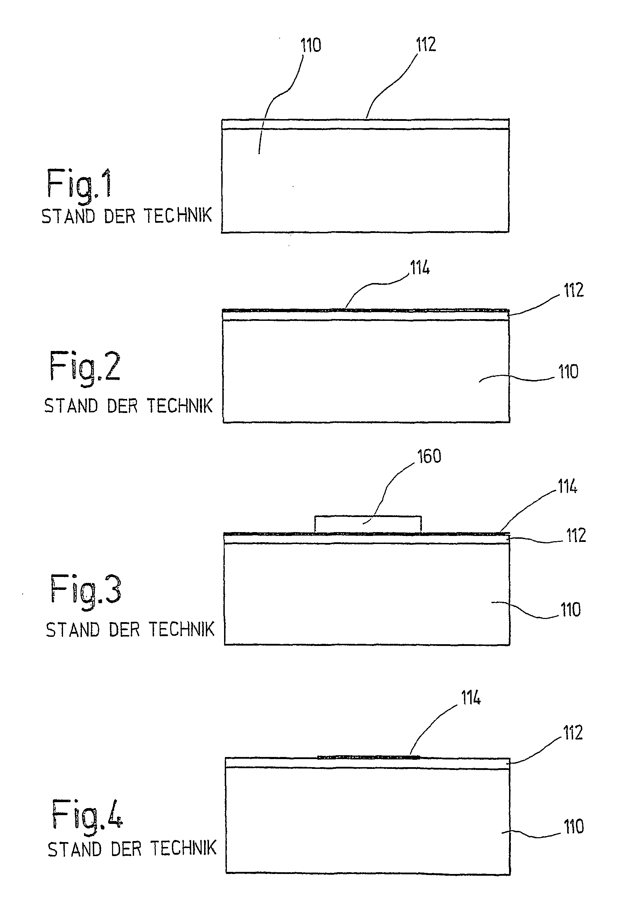

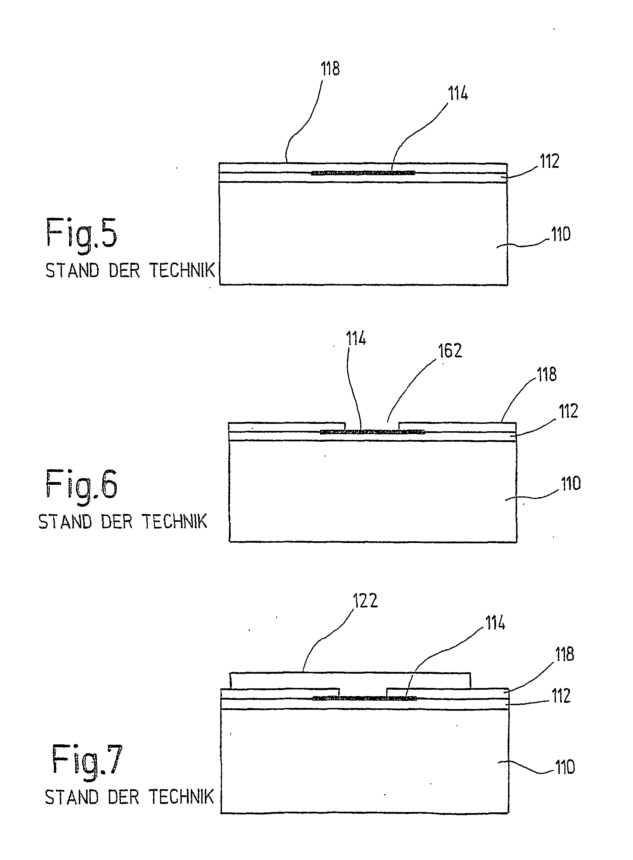

Gemäß Figur 5 wird nun auf die Anordnung gemäß Figur 4 zusätzlich eine Passivierungsschicht 118 abgeschieden. Diese kann zum Beispiel aus Siliziumdioxid, Siliziumnitrid und vergleichbaren Materialien bestehen.

Figur 6 zeigt einen Zustand, der auf Figur 5 aufbaut.. In der hier dargestellten Schichtanordnung ist die Passivierungsschicht 118 strukturiert, so dass ein Kontaktloch 162 entsteht.

In Figur 7 ist dann ein Zustand dargestellt, welcher aus dem Zustand gemäß Figur 6 hervorgeht, indem ein Kontaktmetall 122 abgeschieden wird. Dieses Kontaktmetall 122 stellt mit der GMR-Schicht 114 über die Kontaktöffnung 162 einen elektrischen Kontakt her.

Will man nun das GMR-Element und die zur Auswertung der Magnetowiderstände erforderliche Auswerteelektronik auf einem Chip integrieren, so ist bei der Verwendung des dargestellten Herstellungsprozesses für die GMR-Struktur einiges zu beachten. Beispielsweise werden in der Metallebene, das heißt in der Vielfachschicht 114 gemäß Figur 2 Materialien eingesetzt, welche in der Umgebung einer CMOS-Struktur aus Kontaminationsgründen nicht eingesetzt werden können. Daher muss bei der Prozesssequenz auf eine sequentielle Herstellung zunächst der CMOS-Struktur und dann erst des GMR-Elementes geachtet werden. Dabei ist insbesondere nachteilig, dass Lithographieebenen im metallkontaminierten Teil der Prozesssequenz erforderlich sind, wie anhand, von Figur 3 und Figur 4 erläutert wurde.

### Vorteile der Erfindung

Die Erfindung baut auf dem gattungsgemäßen Verfahren dadurch auf, dass der Träger vor dem Aufbringen der metallischen Vielfachschicht eine Struktur aufweist und dass das Strukturieren der metallischen Vielfachschicht durch chemisch-mechanisches Polieren (CMP; "chemical mechanical polishing") erfolgt. Die Struktur der GMR-Schichten, beispielsweise eine typische Mäanderstruktur, wird daher bereits vor dem Aufbringen der metallischen Vielfachschicht zumindest teilweise durch die Strukturierung des Substrats beziehungsweise der auf dem Substrat angeordneten Isolationsschicht, beispielsweise SiO₂, vorbestimmt. Nach dem großflächigen Abscheiden der metallischen Vielfachschicht werden die Metallagen durch CMP wieder entfernt. In den Vertiefungen werden die GMR-Strukturen jedoch nicht abgetragen. Ein Strukturieren der GMR-Schicht durch Lithographie und kostenintensive Trockenätzverfahren sind daher entbehrlich.

Es ist bevorzugt, dass der strukturierte Träger durch Strukturieren eines Halbleitersubstrats und nachfolgendes Abscheiden einer Isolationsschicht erzeugt wird. Die Vertiefungen, welche letztlich die GMR-Struktur bestimmen, können somit beispielsweise durch Trockenätzverfahren in ein Siliziumsubstrat eingebracht werden. Die Struktur bleibt dann nach dem Abscheiden einer Isolationsschicht, beispielsweise auf der Grundlage eines 0,5 bis 1,5 µm dicken thermischen Oxids, erhalten.

Es ist vorteilhaft, wenn vor dem Strukturieren der metallischen Vielfachschicht durch CMP eine Passivierungsschicht abgeschieden wird. Die GMR-Schicht ist auf diese Weise in den nachfolgenden Prozessschritten geschützt.

Es kann aber auch nützlich sein, dass nach und/oder vor dem Strukturieren der metallischen Vielfachschicht durch CMP eine Passivierungsschicht abgeschieden wird. Diese Passivierungsschicht kann die erste Passivierungsschicht sein, die während des Prozesses abgeschieden wird. Es kann aber auch nützlich sein, diese Passivierungsschicht abzuscheiden, wenn bereits vor dem Strukturieren der metallischen Vielfachschicht eine Passivierungsschicht abgeschieden wurde. Im ersten Fall, das heißt, die nach dem Strukturieren der metallischen Vielfachschicht abgeschiedene Passivierungsschicht ist die erste Passivierungsschicht, deckt die Passivierungsschicht die bereits strukturierte GMR-Schicht ab. In dem Fall, dass bereits vor dem Strukturieren der metallischen Vielfachschicht eine Passivierungsschicht abgeschieden wurde, dient die nach dem Strukturieren der metallischen Vielfachschicht abgeschiedene Passivierungsschicht dem Abdecken offener Flanken der GMR-Schicht.

Das erfindungsgemäße Verfahren ist besonders vorteilhaft dadurch weitergebildet, dass die nach dem Strukturieren der metallischen Vielfachschicht durch CMP abgeschiedene Passivierungsschicht strukturiert wird und dass nachfolgend ein Kontaktmetall abgeschieden wird. Auf diese Weise wird eine elektrische Verbindung der GMR-Struktur zu anderen Komponenten ermöglicht.

In diesem Zusammenhang ist es besonders bevorzugt, dass das Strukturieren des Halbleitersubstrates im Rahmen der Strukturierung einer integrierten Schaltung auf demselben Halbleitersubstrat erfolgt. Die Definition der GMR-Struktur kann somit im Rahmen der Strukturierung des Halbleitersubstrates für integrierte Schaltungen verwendet werden, beispielsweise für CMOS-Strukturen als Bestandteil der Auswerteschaltung der GMR-Strukturen.

Das Verfahren ist besonders dadurch vorteilhaft weitergebildet, dass.die metallische Vielfachschicht in einem ersten Bereich aufgebracht wird, in welchem die GMR-Struktur erzeugt werden soll und dass die metallische Vielfachschicht in einem zweiten Bereich aufgebracht wird, in welchem Strukturen für eine integrierte Schaltung vorliegen. Da die metallische Vielfachschicht in Bereichen außerhalb der für die GMR-Struktur vorgesehenen Vertiefungen durch chemisch-mechanisches Polieren entfernt wird, ist es möglich, die metallische Vielfachschicht unspezifisch auf der gesamten Oberfläche eines Wafers aufzubringen. Damit entfallen Maskierungsschritte.

Eine weitere vorteilhafte Ausgestaltung des Verfahrens besteht darin, dass vor dem Abscheiden der Isolationsschicht eine weitere Isolationsschicht aufgebracht wird, dass auf die weitere Isolationsschicht eine Schicht aufgebracht wird, welche mindestens eine leitende Verbindung zwischen dem ersten Bereich und dem zweiten Bereich zur Verfügung stellt, und dass nach dem Abscheiden der Isolationsschicht die Isolationsschicht in dem ersten Bereich strukturiert wird, so dass die nachfolgend aufgebrachte metallische Vielfachschicht einen elektrischen Kontakt zu der mindestens einen elektrischen Verbindung hat. Auf diese Weise wird in einem rationellen Prozess eine elektrische Verbindung zwischen beispielsweise einer CMOS-Struktur und der GMR-Struktur hergestellt. Die leitende Verbindung zwischen der GMR-Struktur und der CMOS-Struktur liegt dann unterhalb der GMR-Struktur.

Das Verfahren ist weiterhin dadurch in vorteilhafter Weise weitergebildet, dass die Isolationsschicht in einem ersten Bereich aufgebracht wird, in welchem die GMR-Struktur erzeugt werden soll, dass die metallische Vielfachschicht in einem zweiten Bereich aufgebracht wird, in welchem Strukturen für eine integrierte Schaltung vorliegen und dass die Isolationsschicht in dem zweiten Bereich als Passivierungsschicht wirkt. In dem ersten Bereich ist die Isolationsschicht somit der Träger für die GMR-Struktur. In dem zweiten Bereich deckt die Isolationsschicht die CMOS-Struktur als Passivierungsschicht ab.

Die Erfindung baut auf der gattungsgemäßen GMR-Struktur dadurch auf, dass die strukturierte metallische Vielfachschicht in einer oder mehreren Vertiefungen des Trägers angeordnet ist. Durch die Anordnung der strukturierten Vielfachschicht in Vertiefungen ist es möglich, die Strukturierung der Vielfachschicht durch chemisch-mechanisches Polieren zu erzeugen. Somit ist es nicht erforderlich, aufwendige Strukturierungsverfahren zu verwenden.

Vorzugsweise umfasst der Träger ein Halbleitersubstrat und eine Isolationsschicht. Die Vertiefung kann daher so in den Träger eingebracht werden, dass zunächst eine Vertiefung in das Halbleitersubstrat eingebracht wird und daraufhin eine Isolationsschicht auf das Halbleitersubstrat aufgebracht wird.

Bevorzugt ist auf der strukturierten Vielfachschicht mindestens eine Passivierungsschicht angeordnet. Die strukturierte Vielfachschicht wird auf diese Weise während des Herstellungsprozesses geschützt.

Die GMR-Struktur ist in vorteilhafter Weise dadurch weitergebildet, dass auf dem Halbleitersubstrat eine integrierte Schaltung vorgesehen ist, dass zwischen der integrierten Schaltung und der metallischen Vielfachschicht mindestens eine leitende Verbindung besteht, welche unterhalb der metallischen Vielfachschicht angeordnet ist, und dass die Kontaktierung der metallischen Vielfachschicht mit der leitenden Verbindung durch eine Öffnung in einer Isolationsschicht realisiert ist. Auf diese Weise ist es beispielsweise möglich, eine Auswerteschaltung und die GMR-Struktur auf demselben Halbleitersubstrat zu realisieren, wobei es ebenfalls möglich ist, Prozessschritte zu integrieren, beispielsweise das Einbringen von Primärstrukturen in das Siliziumsubstrat, entweder zur Vorbereitung der integrierten Schaltung oder zur Vorbereitung der GMR-Struktur.

Die Erfindung besteht ferner in der Verwendung einer der beschriebenen GMR-Strukturen oder einer GMR-Struktur, die nach einem der beschriebenen Verfahren hergestellt wurde, als Weg- und/oder Winkelsensor. Damit entfaltet die vorliegende Erfindung ihre besonderen Vorzüge beispielsweise in der Kraftfahrzeugtechnik. Die GMR-Strukturen bieten mit hohen Effektgrößen und großen Sensitivitäten den Vorteil, große Arbeitsabstände und kompaktee Abmessungen bei geringer Leistungsaufnahme und hoher Temperaturstabilität realisieren zu können.

Der Erfindung liegt die überraschende Erkenntnis zugrunde, dass ein technologischer Prozess zur Verfügung gestellt wird, bei dem die GMR-Metallschicht während des gesamten Herstellungsverfahrens nahezu vollständig durch Passivierungsschichten abgedeckt ist. Auf diese Weise besteht ein geringes Risiko für Cross-Kontamination durch Metalle. Es ist besonders vorteilhaft, dass in bevorzugten Ausführungsformen die Lithographieschritte zur Bearbeitung des Wafers in den CMOS-Teil des Prozesses geschoben werden können, wodurch geringere Investitionen in speziell ausgewiesene Anlagen anfallen. Zur Strukturierung der GMR-Ebene werden CMP-Vorrichtungen verwendet. Diese sind wesentlich kostengünstiger als wartungsintensive IBE-Anlagen oder vergleichbare Strukturierungsanlagen.

### Zeichnungen

Die Erfindung wird nun mit Bezug auf die begleitenden Zeichnungen anhand bevorzugter Ausführungsformen beispielhaft erläutert.

Dabei zeigt:
- Figur 1: einen ersten Zustand während eines Herstellungsverfahrens einer GMR-Struktur des Standes der Technik;
- Figur 2: einen zweiten Zustand während eines Herstellungsverfahrens einer GMR-Struktur des Standes der Technik;
- Figur 3: einen dritten Zustand während eines Herstellungsverfahrens einer GMR-Struktur des Standes der Technik;
- Figur 4: einen vierten Zustand während eines Herstellungsverfahrens einer GMR-Struktur des Standes der Technik;
- Figur 5: einen fünften Zustand während eines Herstellungsverfahrens einer GMR-Struktur des Standes der Technik;
- Figur 6: einen sechsten Zustand während eines Herstellungsverfahrens einer GMR-Struktur des Standes der Technik;
- Figur 7: einen siebten Zustand während eines Herstellungsverfahrens einer GMR-Struktur des Standes der Technik;

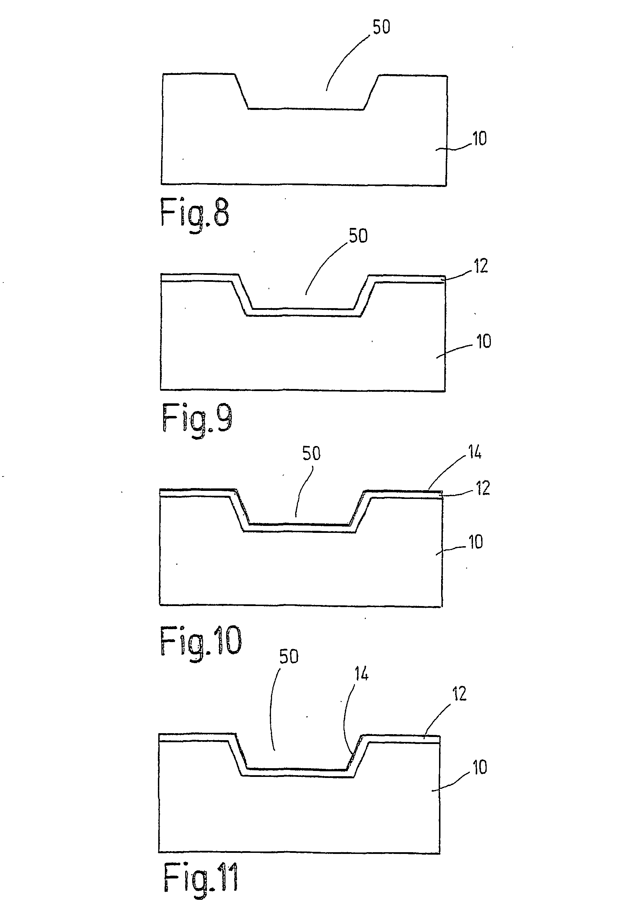

- Figur 8: einen ersten Zustand während eines Herstellungsverfahrens einer GMR-Struktur gemäß der vorliegenden Erfindung;
- Figur 9: einen zweiten Zustand während eines Herstellungsverfahrens einer GMR-Struktur gemäß der vorliegenden Erfindung;
- Figur'10: einen dritten Zustand während eines Herstellungsverfahrens einer GMR-Struktur gemäß der vorliegenden Erfindung;

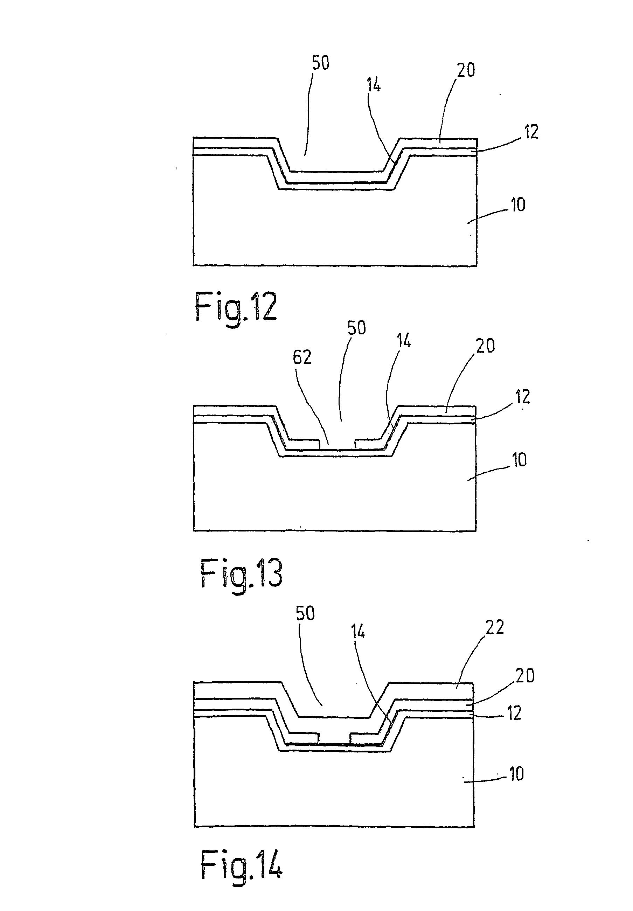

- Figur 11: einen vierten Zustand während eines Herstellungsverfahrens einer GMR-Struktur gemäß der vorliegenden Erfindung;
- Figur 12: einen fünften Zustand während eines Herstellungsverfahrens einer GMR-Struktur gemäß der vorliegenden Erfindung;
- Figur 13: einen sechsten Zustand während eines Herstellungsverfahrens einer GMR-Struktur gemäß der vorliegenden Erfindung;
- Figur 14: einen siebten Zustand während eines Herstellungsverfahrens einer GMR-Struktur gemäß der vorliegenden Erfindung;

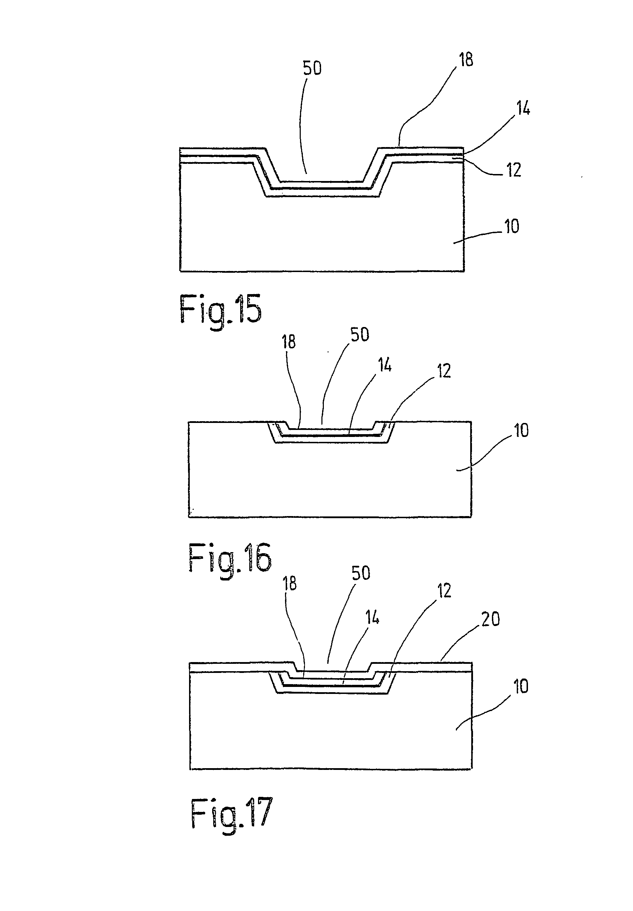

- Figur 15: einen vierten Zustand während eines Herstellungsverfahrens einer GMR-Struktur gemäß einer weiteren Ausführungsform der vorliegenden Erfindung;
- Figur 16: einen fünften Zustand während eines Herstellungsverfahrens einer GMR-Struktur gemäß einer weiteren Ausführungsform der vorliegenden Erfindung;

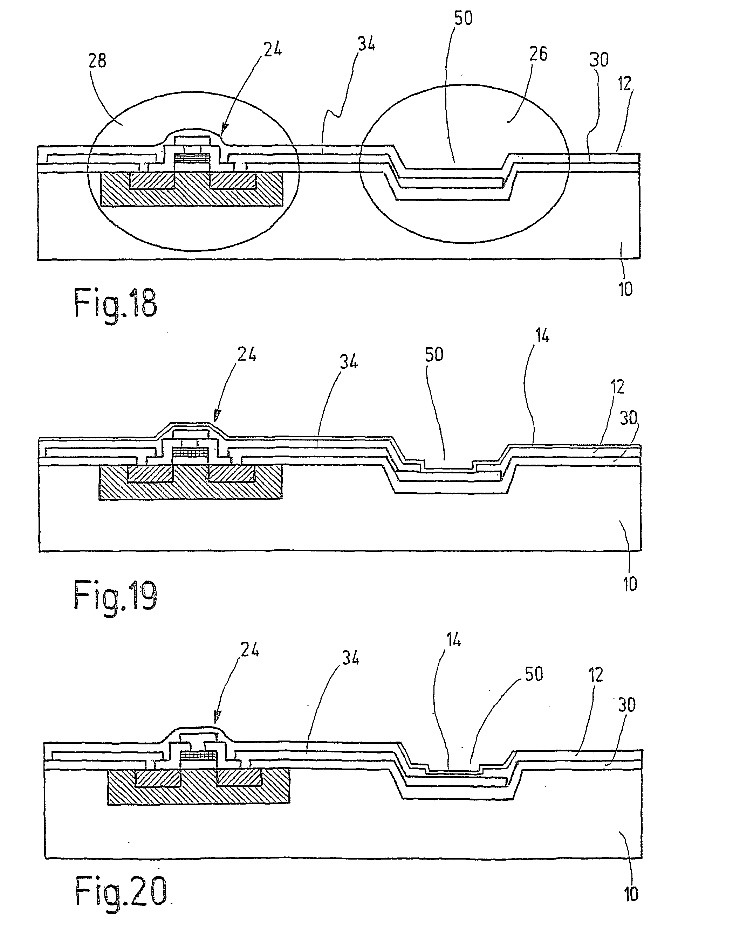

- Figur 17: einen sechsten Zustand während eines Herstellungsverfahrens einer GMR-Struktur gemäß einer weiteren Ausführungsform der vorliegenden Erfindung;
- Figur 18: ein Halbleitersubstrat mit Bereichen für eine GMR-Struktur und eine integrierte Schaltung in einem ersten Verarbeitungszustand;
- Figur 19: ein Halbleitersubstrat mit Bereichen für eine GMR-Struktur und eine integrierte Schaltung in einem zweiten Verarbeitungszustand und
- Figur 20: ein Halbleitersubstrat mit Bereichen für eine GMR-Struktur und eine integrierte .Schaltung in einem dritten Verarbeitungszustand.

### Beschreibung der Ausführungsbeispiele

Figur 8 zeigt ein Halbleitersubstrat, beispielsweise ein Siliziumsubstrat 10, welches eine Vertiefung 50 aufweist. Diese Vertiefung 50 ist beispielsweise mit einem Trockenätzverfahren in das Siliziumsubstrat 10 eingebracht worden.

Figur 9 baut auf der Struktur gemäß Figur 8 auf, wobei eine Isolationsschicht 12 auf das Siliziumsubstrat 10 aufgebracht ist. Diese Isolationsschicht 12 besteht beispielsweise aus einem thermischen Oxid mit einer Dicke von 0,5 bis 1,5 µm.

In Figur 10 ist eine Schichtanordnung dargestellt, die auf der Schichtanordnung gemäß Figur 9 aufbaut. Zusätzlich ist eine metallische Vielfachschicht 14, das heißt eine GMR-Schicht ganzflächig auf die Isolationsschicht 14 aufgebracht. Die Vertiefung 50, welche ursprünglich durch die Strukturierung des Siliziumsubstrats 10 entstanden ist, ist nach wie vor vorhanden.

In Figur 11 ist eine Schichtanordnung dargestellt, welche durch Weiterverarbeitung der Schichtanordnung gemäß Figur 10 entstanden ist. Bei dieser Weiterverarbeitung wurden die überstehenden Metallflächen, das heißt die Metallflächen außerhalb der Vertiefung 50, durch chemisch-mechanisches Polieren (CMP) abgetragen. Es kommt beispielsweise metallselektives CMP oder siliziumselektives CMP in Frage.

In Figur 12 ist ein Zustand dargestellt, welcher durch Abscheiden einer Passivierungsschicht 20 auf die Struktur gemäß Figur 11 entstanden ist.

Figur 13 zeigt einen Zustand, in dem die Passivierungsschicht 20, welche in Figur 12 noch zusammenhängend ist, mit einer Unterbrechung 62 versehen ist. Auf diese Weise wird die Oberfläche der GMR-Struktur 14 teilweise freigelegt.

In Figur 14 wird ein Zustand dargestellt, in dem ein elektrischer Kontakt zu der GMR-Schicht hergestellt ist. Zu diesem Zweck ist ein Kontaktmetall 22 auf die Anordnung gemäß Figur 13 abgeschieden worden. Dieses stellt unter Vermittlung der Vertiefung 62 eine elektrische Verbindung zu der GMR-Struktur 14 her.

Figur 15 zeigt das Ergebnis eines Verfahrensschrittes, welcher auf dem Zustand gemäß Figur 10 aufbaut. Die Figuren 15 bis 17 zeigen somit einen Teil einer Variante des anhand der Figuren 8 bis 14 beschriebenen Verfahrens. Auf die Schichtanordnung gemäß Figur 10 wird eine Passivierungsschicht 18 abgeschieden, so dass die GMR-Schicht 14 praktisch während des gesamten Verfahrens durch die Passivierungsschicht bedeckt und geschützt ist. Als Passivierungsschicht 18 wird beispielsweise ein Niedertemperatur-PECVD-Oxid verwendet.

Figur 16 zeigt den Endzustand eines Verfahrensschrittes, welcher von dem Zustand gemäß Figur 15 ausgeht. In diesem Verfahrensschritt wurde eine Planarisierung durch ein CMP-Verfahren, beispielsweise durch ein Oxid-CMP-Verfahren, durchgeführt.

Figur 17 zeigt den Endzustand eines Verfahrensschrittes, welcher auf dem Zustand gemäß Figur 16 aufbaut. Über die gesamte Struktur gemäß Figur 16 wurde eine Passivierungsschicht 20 abgeschieden. Diese dient der Passivierung der in Figur 16 noch offenen Flanken der GMR-Schicht 14. Dieser Schritt gemäß Figur 17 ist optional.

Ausgehend von den Zuständen gemäß Figur 16 oder Figur 17 können die Verfahrensschritte ausgeführt werden, welche mit Bezug auf die Figuren 13 und 14 beschrieben wurden, das heißt die Strukturierung der Passivierungsschichten 18 beziehungsweise 18 und 20 sowie das Aufbringen eines Kontaktmetalls 22.

Figur 18 zeigt eine Schnittdarstellung durch eine Schichtanordnung. Es sind zwei Bereiche 26, 28 umkreist. In dem Bereich 26 ist eine Vertiefung 50 vorgesehen, welche die Vorstrukturierung für die spätere GMR-Struktur darstellt. In dem Bereich 28 liegen bereits Strukturierungen für integrierte Schaltungen 24 vor. Zwischen dem ersten Bereich 26 und dem zweiten Bereich 28 ist eine leitende Verbindung 34 vorgesehen. Der erste Bereich 26 hat eine Schichtfolge aus Halbleitersubstrat 10, einer unteren Oxidschicht 30, der leitenden Schicht 50 und einer oberen Oxidschicht 12. Die obere Oxidschicht 12 bedeckt die gesamte Anordnung, das heißt auch die Komponenten im Bereich 28. In dem Bereich 28 wirkt die Oxidschicht 12 als Passivierungsschicht.

In Figur 19 ist ein Zustand dargestellt, welcher aus einer Verarbeitung der Struktur gemäß Figur 18 resultiert. Zunächst wurde eine Unterbrechung in die obere Oxidschicht 12 im Bereich der Vertiefung 50 im ersten Bereich 26 eingebracht. Dann wurde ganzflächig über die dargestellte Oberfläche eine metallische Vielfachschicht 14 aufgebracht. Diese kontaktiert aufgrund der Unterbrechung in der oberen Oxidschicht 12 die leitende Verbindung 34. Somit ist die metallische Vielfachschicht elektrisch mit der integrierten Schaltung 24 im zweiten Bereich 28 verbunden. Nachfolgend wird die metallische Vielfachschicht durch chemisch-mechanisches Polieren (CMP) teilweise entfernt. Nur in der Vertiefung 50 verbleibt die metallische Vielfachschicht als GMR-Struktur 14. Die GMR-Struktur 14 ist somit direkt mit der integrierten Schaltung 24 leitend verbunden. Die integrierte Schaltung 24 kann beispielsweise eine Auswerteschaltung für die GMR-Struktur sein.

## Patentansprüche

1. Verfahren zum Herstellen einer GMR-Struktur,
- bei dem auf einem einen Träger (10) bildenden Halbleitersubstrat eine metallische Vielfachschicht (14) aufgebracht wird und
- bei dem die metallische Vielfachschicht (14) zum Erzeugen der GMR-Struktur strukturiert wird,
**dadurch gekennzeichnet,**
- **dass** der Träger (10, 30, 34) vor dem Aufbringen der metallischen Vielfachsrhirht durch eine Vertiefung strukturiert wird,
- **dass** auf den strukturierten Träger (10, 30, 34) eine Isolationsschicht (12) aufgebracht wird,
- **dass** die metallische Vielfachschicht (14) auf die Isolationsschicht (12) des strukturierten Trägers (10, 30, 34) aufgebracht wird
- und **dass** das Strukturieren der metallischen Vielfachschicht (14) durch chemisch mechanisches Polieren CMP erfolgt.

2. Verfahren nach Anspruch 1, **dadurch gekennzeichnet, dass** die Isolationsschicht (12) durch Abscheiden erzeugt wird.

3. Verfahren nach Anspruch 1 oder 2, **dadurch gekennzeichnet, dass** vor dem Strukturieren der metallischen Vielfachschicht (14) durch chemisch mechanisches Polieren CMP eine Passivierungsschicht (18) abgeschieden wird.

4. Verfahren nach einem der vorangehenden Ansprüche, **dadurch gekennzeichnet, dass** nach dem Strukturieren der mechanischen Vielfachschicht (14) durch chemisch mechanisches Polieren CMP eine Passivierungsschicht (20) auf der metallischen Vielfachschicht (14) abgeschieden wird.

5. Verfahren nach einem der vorangehenden Ansprüche, **dadurch gekennzeichnet,**
- **dass** sich nach und/oder vor dem Strukturieren der metallischen Vielfachschicht (14) durch chemisch mechanisches Polieren CMP abgeschiedene Passivierungsschicht (18, 20) strukturiert wird und
- **dass** nachfolgend ein Kontaktmetall (22) abgeschieden wird, zur Herstellung einer elektrisch leitenden Verbindung.

6. Verfahren nach einem der vorangehenden Ansprüche, **dadurch gekennzeichnet, dass** das Strukturieren des Halbleitersubstrates (10) im Rahmen der Strukturierung eine integrierten Schaltung (24) auf demselben Halbleitersubstrat (10) erfolgt.

7. Verfahren nach einem der vorangehenden Ansprüche, **dadurch gekennzeichnet,**
- **dass** die metallische Vielfachschicht (14) in einem ersten Bereich (26) aufgebracht wird, in welchem die GMR-Struktur erzeugt werden soll und
- **dass** die metallische Vielfachschicht (14) in einem zweiten Bereich (28) aufgebracht wird, in welchen Strukturen für eine integrierte Schaltung (24) vorliegen.

8. Verfahren nach einem der vorangehenden Ansprüche, **dadurch gekennzeichnet,**
- **dass** vor dem Abscheiden der Isolationsschicht (12) eine weitere Isolationsschicht (30) aufgebracht wird,
- **dass** auf die weitere Isolationsschicht (30) eine Schicht (32) aufgebracht wird, welche mindestens eine leitende Verbindung (34) zwischen dem ersten Bereich (26) und dem zweiten Bereich (28) zur Verfügung stellt, und
- **dass** nach dem Abscheiden der Isolationsschicht (12) dle Isolationsschicht (12) in dem ersten Bereich (26) strukturiert wird, so dass die nachfolgend aufgebrachte metallische Vielfachschicht (14) einen elektrischen Kontakt zu der mindestens einen elektrischen Verbindung (34) hat.

9. Verfahren nach einem der vorangehenden Ansprüche, **dadurch gekennzeichnet,**
- **dass** die Isolationsschicht (12) in einem ersten Bereich (26) aufgebracht wird, in welchem die GMR-Struktur erzeugt werden soll,
- **dass** die Isolationsschicht (12) in einem zweiten Bereich (28) aufgebracht wird, in welchem Strukturen für eine integrierte Schaltung (24) vorliegend, und
- **dass** die Isolationsschicht (12) in dem zweiten Bereich (28) als Passivierungsschicht wirkt.

10. GMR-Struktur mit
- einem den Träger (10) bildenden Halbleitersubstrat, auf dem eine Isolationsschicht (12) aufgebracht ist und
- einer auf der Isolationsschicht (12) angeordneten strukturierenden metallischen Vielfachschicht,
**dadurch gekennzeichnet,**
- **dass** die strukturierende metallische Vielfachschicht (14) in einer oder mehreren Vertiefungen (50) des Trägers (10) auf der Isolationsschicht (12) angeordnet ist.

11. GMR-Struktur nach Anspruch 10, **dadurch gekennzeichnet, dass** auf der strukturierten metallischen Vielfachschicht (14) mindestens eine Passivierungsschicht (18,20) angeordnet ist.

12. GMR-Struktur nach einem der Ansprüche 10 oder11, **dadurch gekennzeichnet,**
- **dass** auf dem Halbleitersubstrat (10) eine integrierte Schaltung (24) vorgesehen ist,
- **dass** zwischen der integrierten Schaltung (24) und der metallischen Vielfachschicht (14) mindestens eine leitende Verbindung (34) besteht, welche unterhalb der metallischen Vielfachschicht (14) angeordnet ist, und
- **dass** die Kontaktierung der metallischen Vielfachschicht (14) mit der leitenden Verbindung (34) durch eine Öffnung in einer Isolationsschicht (12) realisiert ist.

13. Verwendung einer GMR-Struktur nach einem der Ansprüche 10 bis 12 oder einer nach einem der Ansprüche 1 bis 9 hergestellten GMR-Struktur als Weg- und/oder Winkelsensor.

## Claims

1. Method for producing a GMR structure,
- in which a metallic multiple layer (14) is applied to a semiconductor substrate forming a carrier (10), and
- in which the metallic multiple layer (14) is patterned to produce the GMR structure,
**characterized**
- **in that** the carrier (10, 30, 34) is patterned by a recess prior to the application of the metallic multiple layer,
- **in that** an insulation layer (12) is applied to the patterned carrier (10, 30, 34),
- **in that** the metallic multiple layer (14) is applied to the insulation layer (12) of the patterned carrier (10, 30, 34),
- and **in that** the patterning of the metallic multiple layer (14) is effected by chemical mechanical polishing CMP.

2. Method according to Claim 1, **characterized in that** the insulation layer (12) is produced by depositions.

3. Method according to Claim 1 or 2, **characterized in that** a passivation layer (18) is deposited prior to the patterning of the metallic multiple layer (14) by chemical mechanical polishing CMP.

4. Method according to one of the preceding claims, **characterized in that** a passivation layer (20) is deposited on the metallic multiple layer (14) after the patterning of the metallic multiple layer (14) by chemical mechanical polishing CMP.

5. Method according to one of the preceding claims,
**characterized**
- **in that** the passivation layer (18, 20) deposited after and/or before the patterning of the metallic multiple layer (14) by chemical mechanical polishing CMP is patterned, and
- **in that** subsequently a contact metal (22) is deposited in order to produce an electrically conductive connection.

6. Process according to one of the preceding claims, **characterized in that** the patterning of the semiconductor substrate (10) takes place as part of the patterning of an integrated circuit (24) on the same semiconductor substrate (10).

7. Method according to one of the preceding claims,
**characterized**
- **in that** the metallic multiple layer (14) is applied in a first region (26), in which the GMR structure is to be produced, and
- **in that** the metallic multiple layer (14) is applied in a second region (28), in which there are structures for an integrated circuit (24).

8. Method according to one of the preceding claims,
**characterized**
- **in that** a further insulation layer (30) is applied prior to the deposition of the insulation layer (12),
- **in that** a layer (32), which provides at least one conductive connection (34) between the first region (26) and the second region (28), is applied to the further insulation layer (30), and
- **in that** after the deposition of the insulation layer (12), the insulation layer (12) is patterned in the first region (26), so that the metallic multiple layer (14) which is subsequently applied is in electrical contact with the at least one electrical connection (34).

9. Method according to one of the preceding claims,
**characterized**
- **in that** the insulation layer (12) is applied in a first region (26), in which the GMR structure is to be produced,
- **in that** the insulation layer (12) is applied in a second region (28), in which there are structures for an integrated circuit (24), and
- **in that** the insulation layer (12) acts as a passivation layer in the second region (28).

10. GMR structure having
- a semiconductor substrate, which forms the carrier (10) and to which an insulation layer (12) has been applied, and
- a patterning metallic multiple layer arranged on the insulation layer (12),
**characterized**
- **in that** the patterning metallic multiple layer (14) is arranged on the insulation layer (12) in one or more recesses (50) in the carrier (10).

11. GMR structure according to Claim 10, **characterized in that** at least one passivation layer (18, 20) is arranged on the patterned metallic multiple layer (14).

12. GMR structure according to Claim 10 or 11,
**characterized**
- **in that** an integrated circuit (24) is provided on the semiconductor substrate (10),
- **in that** there is at least one conductive connection (34), which is arranged beneath the metallic multiple layer (14), between the integrated circuit (24) and the metallic multiple layer (14), and
- **in that** the metallic multiple layer (14) is contact-connected to the conductive connection (34) through an opening in an insulation layer (12).

13. Use of a GMR structure according to one of Claims 10 to 12 or of a GMR structure produced as described in one of Claims 1 to 9 as a displacement and/or angle sensor.

## Revendications

1. Procédé de fabrication d'une structure GMR, dans lequel
- une couche multiple métallique (14) est appliquée sur un substrat de semi-conducteur formant un support (10), et
- la couche multiple métallique (14) est structurée pour obtenir la structure GMR,
**caractérisé en ce que**
- le support (10, 30, 34) est structuré par un enfoncement avant l'application de la couche multiple métallique,
- une couche d'isolation (12) est appliquée sur le support structuré (10, 30, 34),
- la couche multiple métallique (14) est appliquée sur la couche d'isolation (12) du support (10, 30, 34) structuré, et
- la structuration de la couche métallique multiple (14) s'effectue par polissage mécano-chimique CMP.

2. Procédé selon la revendication 1,
**caractérisé en ce que**
la couche d'isolation (12) est obtenue par dépôt.

3. Procédé selon la revendication 1 ou 2,
**caractérisé en ce qu'**
une couche de passivation (18) est déposée avant la structuration de la couche multiple métallique (14) par polissage mécano-chimique CMP.

4. Procédé selon l'une quelconque des revendications précédentes,
**caractérisé en ce qu'**
une couche de passivation (20) est déposée sur la couche multiple métallique (14) après la structuration de la couche multiple métallique (14) par polissage mécano-chimique CMP.

5. Procédé selon l'une quelconque des revendications précédentes,
**caractérisé en ce que**
- la couche de passivation (18, 20) déposée après et/ou avant la structuration de la couche multiple métallique (14) par polissage mécano-chimique CMP est structurée, et
- un métal de contact (22) est ensuite déposé pour obtenir une liaison électriquement conductrice.

6. Procédé selon l'une quelconque des revendications précédentes,
**caractérisé en ce que**
la structuration du substrat de semi-conducteur (10) s'effectue dans le cadre de la structuration d'un circuit intégré (24) sur ce même substrat de semi-conducteur (10).

7. Procédé selon l'une quelconque des revendications précédentes,
**caractérisé en ce que**
- la couche multiple métallique (14) est appliquée sur une première zone (26) dans laquelle la structure GMR doit être créée, et
- la couche multiple métallique (14) est appliquée sur une deuxième zone (28) qui comporte des structures pour un circuit intégré (24).

8. Procédé selon l'une quelconque des revendications précédentes,
**caractérisé en ce que**
- une autre couche d'isolation (30) est appliquée avant le dépôt de la couche d'isolation (12),
- une couche (32) est appliquée sur l'autre couche d'isolation (30), qui présente au moins une liaison conductrice (34) entre la première zone (26) et la deuxième zone (28), et
- après le dépôt de la couche d'isolation (12), la couche d'isolation (12) est structurée dans la première zone (26) de telle sorte que la couche multiple métallique (14) appliquée ensuite présente un contact électrique avec au moins une liaison électrique (34).

9. Procédé selon l'une quelconque des revendications précédentes,
**caractérisé en ce que**
- la couche d'isolation (12) est appliquée sur une première zone (26) dans laquelle la structure GMR doit être créée,
- la couche d'isolation (12) est appliquée sur une deuxième zone (28) qui comporte des structures pour un circuit intégré (24), et
- la couche d'isolation (12) agit comme couche de passivation dans la deuxième zone (28).

10. Structure GMR comprenant :
- un substrat de semi-conducteur formant le support (10) sur lequel une couche d'isolation (12) est appliquée, et
- une couche multiple métallique structurée disposée sur la couche d'isolation (12),
**caractérisée en ce que**
la couche multiple métallique (14) structurée est disposée dans un ou plusieurs creux (50) du support (10) sur la couche d'isolation (12).

11. Structure GMR selon la revendication 10,
**caractérisée en ce qu'**
au moins une couche de passivation (18. 20) est disposée sur la couche multiple métallique (14) structurée.

12. Structure GMR selon l'une quelconque des revendications 10 ou 11,
**caractérisée en ce que**
- un circuit intégré (24) est prévu sur le substrat de semi-conducteur (10),
- entre le circuit intégré (24) et la couche multiple métallique (14), au moins une liaison conductrice (34) est disposée sous la couche multiple métallique (14), et
- la mise en contact de la couche multiple métallique (14) avec la liaison conductrice (34) est réalisée par une ouverture dans la couche d'isolation (12).

13. Utilisation d'une structure GMR selon l'une quelconque des revendications 10 à 12, ou d'une structure GMR réalisée selon l'une quelconque des revendications 1 à 9, comme capteur de trajet et/ou d'angle.
